(19) Europäisches Patentamt
European Patent Office
Office européen des brevets

(11) EP 3 263 646 A1

(12) **EUROPEAN PATENT APPLICATION**
published in accordance with Art. 153(4) EPC

(43) Date of publication:
**03.01.2018 Bulletin 2018/01**

(21) Application number: **16755003.7**

(22) Date of filing: **24.02.2016**

(51) Int Cl.:
***C08L 81/02*** *(2006.01)* ***B29C 45/00*** *(2006.01)*
***C08K 3/36*** *(2006.01)* ***C08K 7/02*** *(2006.01)*
***H01L 23/29*** *(2006.01)* ***H01L 23/31*** *(2006.01)*

(86) International application number:
**PCT/JP2016/000985**

(87) International publication number:
**WO 2016/136253 (01.09.2016 Gazette 2016/35)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **25.02.2015 JP 2015035209**
**28.08.2015 JP 2015169013**

(71) Applicant: **Toray Industries, Inc.**
**Tokyo 103-8666 (JP)**

(72) Inventors:
- **OUCHIYAMA, Naoya**
**Nagoya-shi**
**Aichi 455-8502 (JP)**
- **MATSUMOTO, Hideki**
**Nagoya-shi**
**Aichi 455-8502 (JP)**
- **SAITOH, Kei**
**Nagoya-shi**
**Aichi 455-8502 (JP)**
- **HORIUCHI, Shunsuke**
**Nagoya-shi**
**Aichi 455-8502 (JP)**

(74) Representative: **Webster, Jeremy Mark et al**
**Mewburn Ellis LLP**
**City Tower**
**40 Basinghall Street**
**London EC2V 5DE (GB)**

# (54) POLYPHENYLENE SULFIDE RESIN COMPOSITION, MOLDED ARTICLE FORMED FROM SAME, AND METHOD FOR MANUFACTURING SEMICONDUCTOR PACKAGE

(57) There is provided a polyphenylene sulfide resin composition comprising: 5 - 50% by weight of a polyphenylene sulfide resin having a weight-average molecular weight of not less than 10000 and a polydispersity, which is expressed by dividing the weight-average molecular weight by a number-average molecular weight, of not higher than 2.5; and 95 - 50% by weight of (B) fused silica in a spherical form having a volume-average particle diameter of not less than 0.1 μm and less than 1.0 μm, wherein a total of (A) and (B) is kept at 100% by weight.

EP 3 263 646 A1

## Description

### Technical Field

The present invention relates to a polyphenylene sulfide resin composition that has low gas generation, low impurity, high heat resistance, high dimensional stability, high arc resistance (high insulation) and excellent molding processability and is configured to suppress a short circuit of an electronic component and cracking of a molded product due to thermal expansion under a high temperature environment and to prevent deformation of a bonding wire or the like such as to be suitable as a semiconductor component sealing material, as well as to a method of producing the same and a semiconductor component formed therefrom.

### Related Art

A polyphenylene sulfide resin (hereinafter abbreviated as PPS resin) has a high melting point and favorable properties such as excellent flame retardancy, rigidity, insulation and chemical resistance to be suitable as an engineering plastic. A PPS resin is mainly molded by injection molding and is widely used as various types of electric and electronic components, machine components, automobile components, and household electric appliances.

With the recent requirements for the high functionality, downsizing and speed-up of electronic devices, semiconductor is increasingly used for the high performance and multi-functional applications and is applied in various fields such as household electric appliances, computers, automobiles, railways, solar and wind power generation. The advanced design technique is required with the diversified demands for semiconductor packages (for the purpose of enhancement of protective performance from the external environment, enhancement of electrical connectivity with the outside, enhancement of radiation performance and enhancement of mountability). In the field of mono-functional (discrete) semiconductor, power-semiconductor SiC elements have been newly developed to replace Si elements. The SiC element has the higher performance and the higher amount of heat generation during operation than the Si element and is accordingly expected to increase the internal temperature of a product from the conventional level that is about 150°C to about 250°C - 300°C. There is accordingly a demand for a resin material having high heat resistance, such as a PPS resin, a PI resin and a PAI resin.

Conventionally thermosetting epoxy resins have been mainly used as the sealing material of semiconductor packages. The inexpensive general-purpose resin has the heat resistance temperature of about 150°C and is thus likely to cause a problem of material degradation due to thermal decomposition and have high restrictions in product design in the application of next-generation SiC power semiconductor. Attention has accordingly been drawn to the PPS resin material having the heat resistance temperature of not lower than 200°C with little degradation of the intrinsic resin properties and excellent molding processability. A semiconductor component to be sealed is generally comprised of an Si chip or an SiC chip and a lead frame and is configured such that electrical continuity is established by connection of the lead wire with an aluminum circuit by means of a bonding wire made of Au or Al material. A method of manufacturing a semiconductor package generally used for the PPS resin material places a silicon chip in advance in a mold and seals the silicon chip by injection molding. When the PPS resin material has insufficient fluidity, however, high-speed, high-pressure molding is likely to cause a crush of the bonding wire. Additionally, the high content of ionic impurities (for example, sodium, chlorine and iodine) in the PPS resin material is likely to cause problems, for example, corrosion of an electrode terminal or a bonding wire in a wet heat environment. There is accordingly a high demand for the PPS resin material that solves these problems.

For example, Patent Literature 1 discloses a resin composition comprising: a PPS resin having a weight-average molecular weight of not less than 10000 and a polydispersity, which is expressed as weight-average molecular weight / number-average molecular weight, of not higher than 2.5; and an inorganic filler having an average particle diameter of 1 - 100 $\mu$m.

Patent Literature 2 discloses a resin composition for sealing an electronic component, which comprises a linear polyarylene sulfide resin, an inorganic ion exchanger, an ethylene copolymer and spherical silica having an average particle diameter of 0.5 - 40 $\mu$m.

Patent Literature 3 discloses a polyarylene sulfide resin composition for sealing an electronic component, which comprises a polyarylene sulfide resin, silica, an elastomer and epoxysilane.

### Citation List

#### Patent Literature

Patent Literature 1: JP 2008-231138A (claims, examples)
Patent Literature 2: JP 2000-034407A (claims, examples)
Patent Literature 3: JP 2000-186209A (claims, examples)

Summary

Technical Problem

The resin composition described in Patent Literature 1 has the reduced amount of gas generation and the improved molding processability. Due to the large size of the filler that is mixed, however, the resin composition is likely to cause deformation of the bonding wire during sealing of a semiconductor package by injection molding. This resin composition accordingly has not reached the practically satisfactory level.

In the resin composition described in Patent Literature 2, certain improvement in deformation of the bonding wire during injection molding is achieved by reducing the size of the filler. The high content of the ionic impurity and the high gas generation of the resin composition are, however, likely to cause metal corrosion and additionally make voids during injection molding. This resin composition accordingly has not reached the practically satisfactory level.

In the resin composition described in patent Literature 3, the improvement in the fluidity suppresses deformation of the bonding wire during injection molding and thereby improves the sealing properties of electric and electronic components. This resin composition, however, fails to solve the problem of the occurrence of voids due to an increase in the amount of gas generation. This resin composition accordingly has not reached the practically satisfactory level.

An object of the present invention is thus to provide a polyphenylene sulfide resin composition that suppresses deformation of the bonding wire during injection molding without damaging the characteristics of the polyphenylene sulfide resin having the low gas generation, the low impurity and the high heat resistance, has excellent arc resistance and excellent dimensional stability and is suitable as a sealing material for a semiconductor component, and provide a molded product formed therefrom.

Solution to Problem

In order to solve at least part of the problems described above, the invention may be implemented by aspects described below.

1. A polyphenylene sulfide resin composition, comprising: 5 - 50% by weight of a component (A) that is a polyphenylene sulfide resin having a weight-average molecular weight of not less than 10000 and a polydispersity, which is expressed by dividing the weight-average molecular weight by a number-average molecular weight, of not higher than 2.5; and 95 - 50% by weight of a component (B) that is fused silica in a spherical form having a volume-average particle diameter of not less than 0.1 μm and less than 1.0 μm, wherein a total of the components (A) and (B) is kept at 100% by weight.
2. The polyphenylene sulfide resin composition according to Aspect 1, wherein an extracting solution obtained by hot water extraction (20 g of a sample / 100 ml of deionized water) at 160°C for 20 hours of a molded product formed from the polyphenylene sulfide resin composition has a sodium content of lower than 50 ppm, a chlorine content of lower than 50 ppm and an iodine content of lower than 50 ppm.
3. The polyphenylene sulfide resin composition according to either Aspect 1 or Aspect 2, further comprising 1 - 50 parts by weight of (C) a fibrous and/or non-fibrous filler other than (B) the fused silica, relative to 100 parts by weight of the component (B).
4. The polyphenylene sulfide resin composition according to any one of Aspects 1 to 3, wherein the component (A) is a polyphenylene sulfide resin that includes at least 50% by weight or more of a cyclic polyphenylene sulfide expressed by General Formula (I) given below:

[Chem. 1]

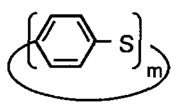

... (I)

(wherein m is an integral number of 4 - 20, and the component (A) is allowed to be configured as a mixture of multiple different types of cyclic polyphenylene sulfides having different numbers m) and that is obtained by heating a polyphenylene sulfide prepolymer having a weight-average molecular weight of less than 10000 such as to be

converted to a high molecular-weight polymer having a weight-average molecular weight of not less than 10000.
5. A molded product formed from the polyphenylene sulfide resin composition according to any one of Aspects 1 to 4.
6. A method of producing a semiconductor package, comprising sealing a semiconductor component by injection molding the polyphenylene sulfide resin composition according to any one of Aspects 1 to 4.

## Advantageous Effects of Invention

The present invention provides a polyphenylene sulfide resin composition. The polyphenylene sulfide resin composition of the present invention is obtained by mixing the PPS resin having the weight-average molecular weight of not less than 10000 and the polydispersity, which is expressed by dividing the weight-average molecular weight by the number-average molecular weight, of not higher than 2.5, with the fused silica in the spherical form having the volume-average particle diameter of not less than 0.1 μm and less than 1.0 μm. The polyphenylene sulfide resin composition obtained has the excellent fluidity, heat resistance, dimensional stability and arc resistance and the low gas generation and the low content of ionic impurities. The polyphenylene sulfide resin composition of the present invention includes the fused silica having the volume-average particle diameter in the range of not less than 0.1 μm and less than 1.0 μm. This prevents significant reduction of the fluidity. Accordingly this configuration provides a semiconductor package that suppresses deformation of a bonding wire during sealing of the semiconductor package by injection molding and has excellent dimensional stability at high temperature.

## Brief Description of Drawings

[Figure 1] Fig. 1 is a schematic diagram illustrating a molded product that is subject to evaluation for mold deposit in Examples.

## Description of Embodiments

### 1. Embodiment of Invention

The following describes an embodiment of the invention in detail. The following sequentially describes components (A), (B) and (C) of the polyphenylene sulfide resin composition of the invention and subsequently describes (D) a resulting polyphenylene sulfide resin composition.

(A) Polyphenylene sulfide resin having a weight-average molecular weight of not less than 10000 and a polydispersity, which is expressed by dividing the weight-average molecular weight by a number-average molecular weight, of not higher than 2.5

The polyphenylene sulfide resin (A) according to the embodiment of the invention is a homopolymer or copolymer that has a repeating unit expressed by a formula -(Ar-S-)- as the main structural unit and preferably contains not lower than 80 mol% of this repeating unit. Ar may be any of units expressed by, for example, Formula (a) to Formula (k) given below and is especially preferably Formula (a) among them.

[Chem. 2]

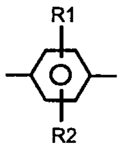
...(a)

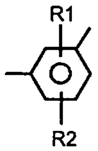
...(b)

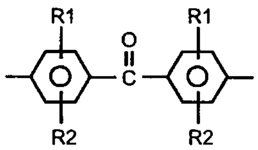
...(c)

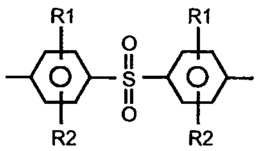
...(d)

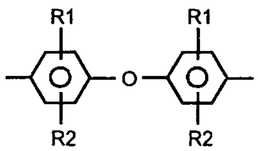
...(e)

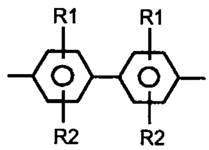
...(f)

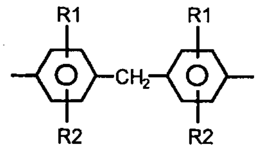
...(g)

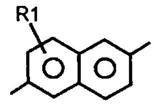
...(h)

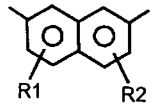
...(i)

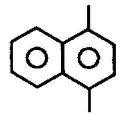
...(j)

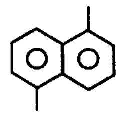
...(k)

(where each of R1 and R2 represents a substituent group selected from the group consisting of hydrogen, alkyl groups containing 1 to 12 carbon atoms, alkoxy groups containing 1 to 12 carbon atoms, arylene groups containing 6 to 24 carbon atoms and halogen groups, and R1 and R2 may be identical with each other or may be different from each other).

As long as the polyphenylene sulfide resin (A) has this repeating unit as the main structural unit, the polyphenylene sulfide resin (A) may include a small amount of a branch unit or a crosslinking unit expressed by, for example, any of Formula (l) to Formula (n) given below. A copolymerization amount of such a branch unit or crosslinking unit is preferably in a range of 0 to 1 mol% relative to 1 mol of the -(Ar-S)- unit.

[Chem. 3]

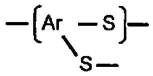
...(l)

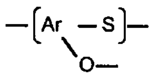
...(m)

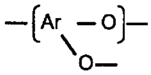
...(n)

The polyphenylene sulfide resin (A) according to the embodiment of the invention may be a random copolymer or a block copolymer including the above repeating unit or may be a mixture thereof.

Typical examples of the polyphenylene sulfide resin (A) include polyphenylene sulfide, polyphenylene sulfide sulfone, polyphenylene sulfide ketone, their random copolymers, their block copolymers and mixtures thereof.

[Chem. 4]

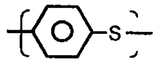

An especially preferable PAS resin (A) is a polyphenylene sulfide resin containing not lower than 80 mol% or more specifically containing not lower than 90 mol% of a p-phenylene sulfide unit given above as the main structural unit of the polymer.

The lower limit of the average molecular weight(weight-average molecular weight) of the polyphenylene sulfide resin (A) according to the embodiment of the invention may be not less than 10000, is preferably not less than 15000 and is more preferably not less than 18000. The upper limit of the average molecular weight (weight-average molecular weight) of the polyphenylene sulfide resin (A) may be not greater than 100000, is preferably not greater than 50000 and is more preferably not greater than 30000. The polyphenylene sulfide resin (A) having the lower limit of the weight-average molecular weight of less than 10000 increases the amount of gas generation during molding processing and thereby reduces the moldability and the mechanical strength of a molded product. The polyphenylene sulfide resin (A) having the upper limit of the weight-average molecular weight of greater than 100000, on the other hand, slows solidification in a mold and is thereby likely to cause insufficient crystallization of a molded product and to fail to provide the sufficient effect of enhancing the heat resistance. The smaller weight-average molecular weight of the polyphenylene sulfide resin (A) according to the embodiment of the invention leads to the faster solidification of the resin in the mold. This results in achieving high crystallization of a molded product and thereby remarkably improves the heat resistance.

The distribution of the molecular weight of the polyphenylene sulfide resin (A) according to the embodiment of the invention, i.e., the polydispersity expressed as a ratio of the weight-average molecular weight to the number-average molecular weight (weight-average molecular weight / number-average molecular weight) is, for example, not higher than 2.5, is more preferably not higher than 2.3, is furthermore preferably not higher than 2.1 and is especially preferably not higher than 2.0. The polydispersity of not higher than 2.5 is more likely to reduce the content of low-molecular components included in the polyphenylene sulfide resin (A). The low content of the low-molecular components included in the polyphenylene sulfide resin (A) is likely to achieve, for example, improvement in the mechanical properties when the polyphenylene sulfide resin (A) is used in the applications of molding processing, reduction in the amount of gas generation on heating, and reduction in the amount of eluted component when the polyphenylene sulfide resin (A) is exposed to a solvent. The weight-average molecular weight and the number-average molecular weight described above may be determined by using SEC (size exclusion chromatography) equipped with a differential refractive index detector.

The melt viscosity of the polyphenylene sulfide resin (A) according to the embodiment of the invention is not specially limited but is generally in a range between the lower limit of 5 Pa·s (at 300°C, shear rate of 1000/sec) and the upper limit of 10,000 Pa·s (at 300°C, shear rate of 1000/sec) as the preferable range. The polyphenylene sulfide resin (A) having the melt viscosity in this range is likely to provide excellent molding processability.

The content of alkali metal included as the impurity in the polyphenylene sulfide resin (A) used according to the embodiment of the invention is not specifically limited but is preferably lower than 700 ppm as the weight ratio in the application of a semiconductor member requiring the electric insulation. The alkali metal content of not lower than 700 ppm causes a problem, such as reduction of the electric insulation by the metal impurity and is thus not preferable. From the viewpoint of reduction of the electric insulation described above, the alkali metal content in the polyphenylene sulfide resin (A) is especially preferably lower than 100 ppm as the weight ratio. The alkali metal content in the polyphenylene sulfide resin (A) according to the embodiment of the invention may be, for example, a value calculated from the amount of alkali metal included in the ash content that is the residue when the polyphenylene sulfide resin (A) is fired by using an electric oven or the like. The ash content may be quantitatively determined by ion chromatography or by atomic absorption spectrophotometry.

Here the alkali metal indicates the metals of group IA in the periodic table such as lithium, sodium, potassium, rubidium, cesium, and francium. It is, however, preferable that the polyphenylene sulfide resin (A) according to the embodiment of the invention includes no alkali metal other than sodium. Containing an alkali metal other than sodium is likely to adversely affect the electric properties and the thermal properties of the polyphenylene sulfide resin composition. This is also likely to cause an increase in the amount of an eluting metal when the polyphenylene sulfide resin (A) is exposed to a solvent. This tendency is more remarkable when the polyphenylene sulfide resin (A) contains lithium. Among various metal species, the alkali metals are likely to have the stronger effects on the electric properties and the thermal properties of the polyphenylene sulfide resin composition and on the amount of the eluting metal, compared with metal species other than the alkali metals, for example, alkaline earth metals and transition metals. Among various metal species, especially the alkali metal content in the above range is thus expected to improve the quality of the polyphenylene sulfide resin (A).

The weight reduction ratio on heating of the polyphenylene sulfide resin (A) according to the embodiment of the invention preferably satisfies Expression (1) given below:

$$\Delta Wr = (W1 - W2) / W1 \times 100 \leq 0.18(\%) \qquad (1)$$

ΔWr herein denotes a weight reduction ratio (%). ΔWr is a value calculated from a sample weight (W2) at temperature reaching 330°C relative to a sample weight (W1) at temperature reaching 100°C in thermogravimetric analysis at a temperature rise rate of 20°C/ minute from 50°C to an arbitrary temperature of not lower than 330°C in a non-oxidizing atmosphere at ordinary pressure.

The weight reduction ratio ΔWr of the polyphenylene sulfide resin (A) used according to the embodiment of the invention is preferably not higher than 0.18%, is more preferably not higher than 0.12%, is further preferably not higher than 0.10%, and is furthermore preferably not higher than 0.085%. Although the lower limit of the weight reduction ratio ΔWr is 0%, the ratio of not lower than 0.001% cases practically no problem. When ΔWr exceeds the above range, this is likely to cause a problem, such as an increase in the amount of gas generation during molding processing of the PPS resin composition including the polyphenylene sulfide resin (A). This is also undesirably likely to decrease the mechanical strength of a molded product. Furthermore, this is undesirably likely to increase the deposit on the mold during injection molding and reduce the productivity.

ΔWr may be determined by general thermogravimetric analysis. This analysis is performed in a non-oxidizing atmosphere at ordinary pressure. The non-oxidizing atmosphere herein indicates an atmosphere having the oxygen concentration of not higher than 5% by volume in the gas phase to which a sample is exposed, preferably an atmosphere having the oxygen concentration of not higher than 2% by volume and more preferably an atmosphere that contains substantially no oxygen, i.e., an inert gas atmosphere such as nitrogen, helium or argon. Among them, nitrogen atmosphere is especially preferable in terms of the economic efficiency and the ease of handling. The ordinary pressure indicates a pressure in the approximately standard state of the atmosphere and is an atmospheric condition of approximately 101.3 kPa as the absolute pressure at the temperature of approximately 25°C. In a measurement atmosphere other than the atmosphere described above, there is a possibility that the measurement does not provide the result in conformity with the actual use of the PPS resin, for example, the occurrence of oxidation of the PPS resin during measurement or a significant difference from the atmosphere actually used in the molding processing of the PPS resin.

In the measurement of ΔWr, thermogravimetric analysis is performed by increasing the temperature from 50°C to an arbitrary temperature of not lower than 330°C at a temperature rise rate of 20°C/ min. Thermogravimetric analysis is preferably performed by increasing the temperature at a temperature rise rate of 20°C/ min after keeping the temperature at 50°C for one minute. This temperature range is a temperature range frequently employed in the actual use of the polyphenylene sulfide resin. This temperature range is also a temperature range frequently employed in the process of melting PPS in the solid state and subsequently molding the melted PPS into an arbitrary shape. The weight reduction ratio in such an actual use temperature range is related to the amount of gas generation from the PPS resin in the actual use and the amount of deposit on the mold in the molding processing. The PPS resin having the lower weight reduction ratio in this temperature range is thus regarded as the better PPS resin having the higher quality. The sample weight in the measurement of ΔWr is preferably approximately 10 mg, and the sample is preferably fine particles of approximately 2 mm or smaller.

The reason why the polyphenylene sulfide resin (A) used according to the embodiment of the invention provides such an excellent thermogravimetric characteristic that the weight reduction ratio of the polyphenylene sulfide resin (A) on heating satisfies Expression (1) given above is not clear at the moment. This may, however, be attributable to that the polyphenylene sulfide resin (A) used according to the embodiment of the invention has a low impurity content other than the PPS content.

The PPS resin (A) having the characteristic expressed by Expression (1) given above is preferably produced by heating a polyphenylene sulfide prepolymer including a cyclic polyphenylene sulfide such as to be converted to a high molecular-weight polymer as described later. The conversion to the high molecular-weight polymer will be described later in detail. The weight fraction of the cyclic PPS included in a resulting PPS resin obtained by the operation for converting the polyphenylene sulfide prepolymer into the high molecular-weight polymer is preferably not higher than 40%, is more preferably not higher than 25% and is furthermore preferably not higher than 15%. Such a PPS resin is preferable since this provides the especially smaller value of ΔWr described above. The value of weight fraction of the cyclic PPS exceeding the above range is likely to increase the value of ΔWr. This reason is not clear at the moment but may be attributable to volatilization of part of the cyclic PPS included in the PPS resin in the heating process.

As long as the weight reduction ratio on heating of the polyphenylene sulfide resin (A) used according to the embodiment of the invention satisfies Expression (1) given above, the weight-average molecular weight, the polydispersity, and the alkali metal content of the PPS resin (A) are not necessary to be in the above ranges. The PPS resin including a certain amount of the cyclic PPS as described above may also satisfy the thermogravimetric characteristic expressed by Expression (1). The weight-average molecular weight, the polydispersity, and the alkali metal content of the PPS resin in the above ranges are, however, preferable since this is likely to provide the especially low weight

reduction ratio on heating.

The PPS resin (A) used according to the embodiment of the invention has the excellent characteristic of the low weight reduction ratio ΔWr on heating with a temperature rise as described above. The PPS resin (A) is also likely to have the excellent characteristic of a low decrease rate of weight between before and after heating (low weight loss by heating) when the PPS resin (A) is kept at an arbitrary fixed temperature.

The polyphenylene sulfide resin (A) used according to the embodiment of the invention is characterized by that the generation amount of a lactone-type compound and/or an aniline-type compound by heating is extremely small. Here examples of the lactone-type compound include β-propiolactone, β-butyrolactone, β-pentanolactone, β-hexanolactone, β-heptanolactone, β-octanolactone, β-nonalactone, β-decalactone, γ-butyrolactone, γ-valerolactone, γ-pentanolactone, γ-hexanolactone, γ-heptanolactone, γ-octalactone, γ-nonalactone, γ-decalactone, δ-pentanolactone, δ-hexanolactone, δ-heptanolactone, δ-octanolactone, δ-nonalactone, and δ-decalactone. Examples of the aniline-type compound include aniline, N-methylaniline, N,N-dimethylaniline, N-ethylaniline, N-methyl-N-ethylaniline, 4-chloroaniline, 4-chloro-N-methylaniline, 4-chloro-N,N-dimethylaniline, 4-chloro-N-ethylaniline, 4-chloro-N-methyl-N-ethylaniline, 3-chloroaniline, 3-chloro-N-methylaniline, 3-chloro-N,N-dimethylaniline, 3-chloro-N-ethylaniline, and 3-chloro-N-methyl-N-etylaniline. Generation of the lactone-type compound and/or the aniline-type compound in the process of heating the polyphenylene sulfide resin (A) may cause foaming of the resin and mold deposit in the molding processing. Such foaming of the resin and mold deposit in the molding processing not only deteriorate the molding processability but induce pollution of the surrounding environment. It is accordingly preferable to minimize such foaming and mold deposit. Generation of the lactone-type compound relative to the weight of the PAS before heating is preferably not higher than 500 ppm, is more preferably not higher than 300 ppm, is further preferably not higher than 100 ppm, and is furthermore preferably not higher than 50 ppm. Similarly, generation of the aniline-type compound is preferably not higher than 300 ppm, is more preferably not higher than 100 ppm, is further preferably not higher than 50 ppm, and is furthermore preferably not higher than 30 ppm. A method employable to evaluate the generation amount of the lactone-type compound and/or the aniline-type compounds in the process of heating the PAS resin is component separation and quantitative determination of the gas generated in the process of treatment at 320°C for 60 minutes in a non-oxidizing atmosphere by gas chromatography.

The reason of the small generation amounts of such compounds in the process of heating the polyphenylene sulfide resin (A) used according to the embodiment of the invention is not clear at the moment. A polyphenylene sulfide prepolymer used in a preferable production method described below has a high purity including at least 50% by weight of cyclic polyphenylene sulfide. It is expected that this contributes to a small content of the impurity that causes generation of the lactone-type compound and/or the aniline-type compound in heating.

(A1) Production Method of Polyarylene Sulfide

A method employable to produce the polyphenylene sulfide resin (A) according to the embodiment of the invention described above may be a production method by heating a polyphenylene sulfide prepolymer that include at least 50% by weight or more of cyclic polyphenylene sulfide and has a weight-average molecular weight of less than 10,000, such as to be converted to a high molecular-weight polymer having the weight-average molecular weight of not less than 10,000. This method readily provides the polyphenylene sulfide resin (A) of the above characteristics used according to the embodiment of the invention.

A cyclic polyphenylene sulfide (hereinafter may be abbreviated as cyclic PPS) expressed by General Formula (I) given below may be used as the cyclic polyphenylene sulfide in the preferable production method of the polyphenylene sulfide resin (A) used according to the embodiment of the invention. Here m represents an integral number of 4 to 20, and the cyclic polyphenylene sulfide used may be a mixture of multiple different cyclic polyphenylene sulfides having different numbers m.

[Chem. 5]

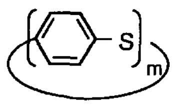 ···(I)

The cyclic polyphenylene sulfide may be either a single compound having a single repetition number or a mixture of cyclic polyphenylene sulfides having different repetition numbers. The mixture of cyclic polyphenylene sulfides having the different repetition numbers is, however, likely to have the lower melting temperature than that of the single compound having the single repetition number. Using the mixture of the cyclic polyphenylene sulfides having the different repetition numbers is thus preferable since this further decreases the temperature in the process of conversion to the

high molecular-weight polymer.

(A2) Polyphenylene Sulfide Prepolymer

The preferable production method of the polyphenylene sulfide resin (A) used according to the embodiment of the invention is characterized by heating the polyphenylene sulfide prepolymer including the cyclic polyphenylene sulfide described above such as to be converted to a high molecular-weight polymer. The polyphenylene sulfide prepolymer used here may include at least not lower than 50% by weight, preferably not lower than 70% by weight, more preferably not lower than 80% by weight and furthermore preferably not lower than 90% by weight of the cyclic polyphenylene sulfide. There is no specific limitation on the upper limit of the content of the cyclic polyphenylene sulfide in the polyphenylene sulfide prepolymer, but a preferable range is not higher than 98% by weight. In general, the higher weight ratio of the cyclic polyphenylene sulfide in the polyphenylene sulfide prepolymer is likely to provide the higher degree of polymerization and the higher melt viscosity of the resulting PPS obtained after heating. In other words, the degree of polymerization and the melt viscosity of the obtained PPS may be readily controlled by adjusting the abundance ratio of the cyclic polyphenylene sulfide in the polyphenylene sulfide prepolymer in the production method of the polyphenylene sulfide resin (A) according to the embodiment of the invention. The weight ratio of the cyclic polyphenylene sulfide in the polyphenylene sulfide prepolymer over the above upper limit is likely to increase the melting temperature of the polyphenylene sulfide prepolymer. The weight ratio of the cyclic polyphenylene sulfide in the polyphenylene sulfide prepolymer in the above range is preferable since this further decreases the temperature in the process of conversion of the polyphenylene sulfide prepolymer to the high molecular-weight polymer.

It is especially preferable that the component other than the cyclic polyphenylene sulfide in the polyphenylene sulfide prepolymer is a linear polyphenylene sulfide oligomer. The linear polyphenylene sulfide oligomer herein has a repetition unit expressed by the formula -(Ar-S)- as the main structural unit and is preferably a homo-oligomer or a co-oligomer containing not lower than 80 mol% of the repetition unit. Ar may be a unit expressed by any of Formula (a) to Formula (k) given above. Among them, Formula (a) is especially preferable. As long as the linear polyarylene sulfide oligomer has this repetition unit as the main structural unit, the linear polyarylene sulfide oligomer may include a small amount of a branch unit or a crosslinking unit expressed by, for example, any of Formula (l) to Formula (n) given above. A copolymerization amount of such a branch unit or crosslinking unit is preferably in a range of 0 to 1 mol% relative to 1 mol of the -(Ar-S)-unit. The linear polyphenylene sulfide oligomer may be a random copolymer or a block copolymer including the above repetition unit or may be a mixture thereof.

Typical examples of the component other than the cyclic polyphenylene sulfide include polyphenylene sulfide oligomer, polyphenylene sulfide sulfone oligomer, polyphenylene sulfide ketone oligomer, their random copolymers, their block copolymers and mixtures thereof. An especially preferable linear polyphenylene sulfide oligomer is linear polyphenylene sulfide oligomer that contains not lower than 80 mol% or especially preferably not lower than 90 mol% of p-phenylene sulfide unit as the main structural unit of the polymer.

It is especially preferable that the amount of the linear polyphenylene sulfide included in the polyphenylene sulfide prepolymer is less than the amount of the cyclic polyphenylene sulfide included in the polyphenylene sulfide prepolymer. More specifically, the weight ratio of the cyclic polyphenylene sulfide to the linear polyphenylene sulfide in the polyphenylene sulfide prepolymer (cyclic polyphenylene sulfide / linear polyarylene sulfide) is preferably not less than 1, is more preferably not less than 2.3, is furthermore preferably not less than 4 and is especially preferably not less than 9. Using such a polyphenylene sulfide prepolymer readily provides polyphenylene sulfide having the weight-average molecular weight of not less than 10,000. Accordingly the higher weight ratio of the cyclic polyphenylene sulfide to the linear polyphenylene sulfide in the polyphenylene sulfide prepolymer is likely to provide the higher weight-average molecular weight of the resulting PPS obtained by the preferable production method of the polyphenylene sulfide resin (A) according to the embodiment of the invention. There is no specific upper limit on this weight ratio. There is, however, a need for significantly reducing the content of the linear PPS in the polyphenylene sulfide prepolymer, in order to obtain the polyphenylene sulfide prepolymer having the weight ratio of greater than 100. This requires a lot of labor. The preferable production method of the polyphenylene sulfide resin (A) according to the embodiment of the invention, however, enables PPS of a sufficiently high molecular weight to be readily obtained by using even the polyphenylene sulfide prepolymer having the weight ratio of not greater than 100.

The upper limit of the molecular weight of the polyphenylene sulfide prepolymer used in the preferable production method of the polyphenylene sulfide resin (A) according to the embodiment of the invention may be lower than 10,000 as the weight-average molecular weight, is preferably not higher than 5,000 and is more preferably not higher than 3,000. The lower limit is, on the other hand, preferably not lower than 300 as the weight-average molecular weight, is more preferably not lower than 400 and is furthermore preferably not lower than 500.

The polyphenylene sulfide resin (A) used according to the embodiment of the invention is characterized by the high purity, so that it is preferable to use the polyphenylene sulfide prepolymer of high purity for production. Accordingly the alkali metal content as the impurity in the polyphenylene sulfide prepolymer is preferably lower than 700 ppm as the

weight ratio, is more preferably not higher than 500 ppm and is furthermore preferably not higher than 300 ppm. When the method of heating the polyphenylene sulfide prepolymer such as to be converted to the high molecular-weight polymer is employed to produce the polyphenylene sulfide resin (A) used according to the embodiment of the invention, the alkali metal content in the resulting PPS is generally dependent on the alkali metal content in the polyphenylene sulfide prepolymer. The alkali metal content in the polyphenylene sulfide prepolymer exceeding the above range is thus likely to cause the alkali metal content in the resulting PPS to exceed the range of the alkali metal content in the polyphenylene sulfide resin (A) according to the embodiment of the invention. The alkali metal content in the polyphenylene sulfide prepolymer herein may be, for example, a value calculated from the amount of alkali metal included in the ash content that is the residue when the polyphenylene sulfide prepolymer is fired using an electric oven or the like. The ash content may be quantitatively determined by ion chromatography or by atomic absorption spectrophotometry.

The alkali metal indicates metals of group IA in the periodic table such as lithium, sodium, potassium, rubidium, cesium, and francium, but it is preferable that the polyarylene sulfide prepolymer according to the embodiment of the invention does not include any alkali metal other than sodium.

In the conversion of the polyphenylene sulfide prepolymer to the high molecular-weight polymer by heating, a catalytic component may be used to accelerate the conversion. An example of this catalytic component may be an ionic compound or a compound that is capable of generating a radical. An example of the ionic compound is an alkali metal sulfide such as sodium salt of thiophenol. An example of the compound that is capable of generating a radical is a compound generating sulfur radical by heating or more specifically a compound containing a disulfide bond. It is preferable that the alkali metal content, the alkali metal species and the halogen species contained in the polyphenylene sulfide prepolymer satisfy the above conditions when the catalytic component is used. In the reaction of heating the polyphenylene sulfide prepolymer such as to be converted to the high molecular-weight polymer, the alkali metal content in the reaction system as the weight ratio is preferably lower than 700 ppm, is more preferably not higher than 500 ppm, and is furthermore preferably not higher than 300 ppm, and the weight ratio of the disulfide content to the total content of sulfur in the reaction system is lower than 1% by weight, is preferably lower than 0.5% by weight, is more preferably lower than 0.3% by weight and is furthermore preferably lower than 0.1% by weight,. This enables the polyphenylene sulfide resin (A) according to the embodiment of the invention to be readily obtained. When the catalytic component is used, the catalytic component is generally incorporated in the PAS, so that the PPS obtained is likely to contain the catalytic component. Especially when an ionic compound containing an alkali metal and/or another metal component is used as the catalytic component, most of the metal component included therein tends to remain in the PPS obtained. The PPS obtained using the catalytic component tends to have the higher weight reduction ratio on heating of the PPS. It is accordingly desirable to minimize the use of the catalytic component or even not to use the catalytic component, in order to obtain the PPS of the higher purity and/or in order to obtain the PPS having the lower weight reduction ratio on heating.

(A3) Production Method of Polyphenylene Sulfide Prepolymer

For example, the following methods may be employed to obtain the polyphenylene sulfide prepolymer.

(A3a) A method of obtaining the polyphenylene sulfide prepolymer includes: polymerizing a polyarylene sulfide resin by heating a mixture containing at least a polyhalogenated aromatic compound, a sulfidizing agent, and a polar organic solvent, such as to prepare a mixture including a granular PPS resin separable by using a 80 mesh sieve (aperture of 0.125 mm), a PPS component other than the granular PPS resin generated by polymerization (called polyphenylene sulfide oligomer), a polar organic solvent, water, and an alkali metal halide; and separating and purifying the polyphenylene sulfide oligomer included in this mixture.

(A3b) A method of recovering the polyphenylene sulfide prepolymer includes: polymerizing a polyphenylene sulfide resin by heating a mixture containing at least a polyhalogenated aromatic compound, a sulfidizing agent, and a polar organic solvent; removing the polar organic solvent by a known method after completion of the polymerization, such as to prepare a mixture including the polyphenylene sulfide resin, water and an alkali metal halide; purifying the mixture by a known method, such as to obtain a polyphenylene sulfide resin including a polyphenylene sulfide prepolymer; and reprecipitating the obtained polyphenylene sulfide resin using a poor solvent.

(A4) Conversion of Polyphenylene Sulfide Prepolymer to High Molecular-Weight Polymer

The polyphenylene sulfide resin (A) according to the embodiment of the invention described above is preferably produced by the above method of heating the above polyphenylene sulfide prepolymer such as to be converted to a high molecular-weight polymer. The temperature of heating is preferably the melting temperature of the above polyphenylene sulfide prepolymer. There is no specific limitation as long as this temperature condition is satisfied. When the heating temperature is lower than the melting temperature of the polyphenylene sulfide prepolymer, it is likely to require a long time period to obtain the high molecular-weight polymer of PPS. The melting temperature of the polyphenylene

sulfide prepolymer is varied depending on the composition and the molecular weight of the polyphenylene sulfide prepolymer as well as the environment during heating and is thus not unequivocally determined. For example, the melting temperature may be specified by analysis of the polyphenylene sulfide prepolymer with a differential scanning calorimeter. The excessively high heating temperature is, however, likely to cause undesired side reactions, such as crosslinking reaction and degradation reaction between the polyphenylene sulfide prepolymer, between the high molecular-weight polymer generated by heating and between the high molecular-weight polymer and the polyphenylene sulfide prepolymer. The excessively high heating temperature is thus likely to deteriorate the characteristics of the PPS resin obtained. It is accordingly desirable to avoid the temperature that significantly causes such undesired side reactions. The heating temperature is, for example, not lower than 180°C, is preferably not lower than 200°C and is more preferably not lower than 250°C. The heating temperature is also, for example, not higher than 400°C, is preferably not higher than 380°C and is more preferably not higher than 360°C.

The time period required for the above heating is varied depending on various properties, for example, the content rate, the repetition number m and the molecular weight of the cyclic polyphenylene sulfide in the polyphenylene sulfide prepolymer used and conditions such as the heating temperature and is thus not unequivocally determined. It is, however, preferable to set the time period required for heating to a time duration that minimizes the undesired side reactions described above. The heating time is, for example, not shorter than 0.05 hour and is preferably not shorter than 0.1 hour. The heating time is also, for example, not longer than 100 hours, is preferably not longer than 20 hours and is more preferably not longer than 10 hours. The heating time of shorter than 0.05 hour is likely to cause insufficient conversion of the polyphenylene sulfide prepolymer to the high molecular-weight polymer. The heating time of longer than 100 hours is, on the other hand, likely to increase the likelihood that adverse effects of the undesired side reactions on the properties of the resulting PPS resin become obvious, and is also likely to be economically disadvantageous.

Conversion of the polyphenylene sulfide prepolymer to the high molecular-weight polymer by heating is generally performed in the absence of a solvent but may be performed in the presence of a solvent. There is no specific limitation on the solvent as long as the solvent does not interfere with the conversion of the polyphenylene sulfide prepolymer to the high molecular-weight polymer by heating or does not practically cause the undesired side reactions such as degradation or crosslinking of the generated high molecular-weight polymer. Examples of the solvent include nitrogen-containing polar solvents such as N-metyl-2-pyrrolidone, dimethylformamide and dimethylacetamide; sulfoxide and sulfone solvents such as dimethyl sulfoxide and dimethyl sulfone; ketone solvents such as acetone, methyl ethyl ketone, diethyl ketone, and acetophenone; ether solvents such as dimethyl ether, dipropyl ether, and tetrahydrofuran; halogenated solvents such as chloroform, methylene chloride, trichloroethylene, ethylene dichloride, dichloroethane, tetrachloroethane, and chlorobenzene; alcoholic and phenolic solvents such as methanol, ethanol, propanol, butanol, pentanol, ethylene glycol, propylene glycol, phenol, cresol, and polyethylene glycol; and aromatic hydrocarbon solvents such as benzene, toluene, and xylene. The supercritical fluid of an inorganic compound such as carbon dioxide, nitrogen, water or the like may also be used as the solvent. Any of these solvents may be used alone or may be used as a mixture of two or more solvents.

Conversion of the polyphenylene sulfide prepolymer to the high molecular-weight polymer by heating described above may be performed by a method using a general polymerization reactor or may also be performed using any device equipped with a heating mechanism without limitation, for example, may be performed in a mold used for producing a molded product or may be performed by using an extruder or a melt kneader. A known method such as a batch method or a continuous method may be employed for such conversion. The atmosphere in the conversion of the polyphenylene sulfide prepolymer to the high molecular-weight polymer by heating is preferably a non-oxidizing atmosphere, and it is also preferable to perform the conversion under a reduced pressure condition. When the conversion is performed under the reduced pressure condition, it is preferable to control the atmosphere in the reaction system first to a non-oxidizing atmosphere and then to the reduced pressure condition. This is likely to suppress the undesired side reactions such as crosslinking reaction and degradation reaction between the polyphenylene sulfide prepolymer, between the high molecular-weight polymer produced by heating and between the high molecular-weight polymer and the polyphenylene sulfide prepolymer. The non-oxidizing atmosphere herein indicates an atmosphere having the oxygen concentration of not higher than 5% by volume in the gas phase to which the polyphenylene sulfide prepolymer is exposed, preferably an atmosphere having the oxygen concentration of not higher than 2% by volume and more preferably an atmosphere that contains substantially no oxygen. The atmosphere that contains substantially no oxygen denotes an inert gas atmosphere such as nitrogen, helium or argon. Among them, nitrogen atmosphere is especially preferable in terms of the economic efficiency and the ease of handling. The reduced pressure condition indicates that the pressure in the reaction system is lower than the atmospheric pressure. The upper limit is preferably not higher than 50 kPa, is more preferably not higher than 20 kPa and is furthermore preferably not higher than 10 kPa. The lower limit of the pressure in the system is, for example, not lower than 0.1 kPa. The pressure of the reduced pressure condition that exceeds the preferable upper limit is likely to cause the undesired side reactions such as crosslinking reaction. The pressure of the reduced pressure condition that is below the preferable lower limit is, on the other hand, likely to volatilize the cyclic polyphenylene sulfide of the low molecular weight included in the polyphenylene sulfide prepolymer, depending on the

reaction temperature.

(B) Fused Silica

The PPS resin composition according to the embodiment of the invention contains the fused silica (B) in the spherical form having the volume-average particle diameter of not less than 0.1 μm and less than 1.0 μm. When the upper limit of the volume-average particle diameter of the fused silica used in the invention is not less than 1.0 μm, this undesirably increases damage to a bonding wire in the process of sealing a semiconductor component by injection molding and reduces the arc resistance as the indication of the insulation property, along with increasing the melt viscosity of the PPS resin composition to deteriorate the molding processability. Here the arc resistance described in the invention means a time duration until the occurrence of insulation breakdown by arc discharge on the surface of a molded product and is measured in conformity with JIS K6911. A concrete measuring method applies such a voltage as to generate arc discharge between two electrodes, which are in contact with the surface of a molded product and are arranged across a predetermined distance. The method subsequently measures a time duration until the surface of a molded product is gradually carbonized with heat generated by arc discharge and is eventually ignited by electrical continuity. Generally the enhanced insulation of a resin material is likely to reduce the possibility of arc discharge on the surface of a molded product and enhance the arc resistance.

When the lower limit of the volume-average particle diameter of the fused silica (B) is less than 0.1 μm, on the other hand, this undesirably reduces the reinforcing effect by a filler and fails to provide sufficient dimensional stability and heat resistance to the PPS resin composition. In order to suppress deformation of a bonding wire in the process of sealing a semiconductor component by injection molding and provide the excellent dimensional stability and heat resistance, the volume-average particle diameter of the fused silica (B) used in the invention needs to be in a range of not less than 0.1 μm and less than 1.0 μm. The upper limit is preferably 0.8 μm and is more preferably 0.7 μm, while the lower limit is preferably 0.3 μm and more preferably 0.5 μm.

Here the volume-average particle diameter of the fused silica (B) denotes an average particle diameter weighted by the volume of each silica particle in a predetermined silica particle group. More specifically the volume-average particle diameter is determined by a laser diffraction and diffusion particle size distribution measuring apparatus (LA-30 manufactured by HORIBA, Ltd.) after weighing 100 mg of fused silica and dispersing the fused silica in water. The morphology of the fused silica (B) used in the invention is preferably spherical since crushed, fibrous or plate-like silica may give significant damage to a bonding wire or a semiconductor element in the process of sealing a semiconductor component by injection molding.

In the PPS resin composition according to the embodiment of the invention, the mixing amount of the fused silica (B) used in the invention is required to be in a range of 50 - 95% by weight relative to the total of (A) and (B) set to 100% by weight. In order to satisfy both the good fluidity and the high strength, the upper limit is preferably 85% by weight and is more preferably 80% by weight, while the lower limit is preferably 60% by weight and is more preferably 65% by weight. Similarly, the mixing amount of the PPS resin (A) is required to be in a range of 5 - 50% by weight. The upper limit is preferably 40% by weight and is more preferably 35% by weight, while the lower limit of the mixing amount of the PPS resin (A) is preferably 15% by weight and is more preferably 20% by weight.

When the mixing amount of the fused silica (B) is lower than 50% by weight, this fails to provide sufficient effect of enhancing the dimensional stability and is likely to cause warpage of a semiconductor package sealed by injection molding. This is likely to cause a defect of a product such as cracking. When the mixing amount of the fused silica (B) exceeds 95% by weight, on the other hand, this remarkably increases the melt viscosity of the resin composition and causes an excess molding pressure to be applied in the process of sealing a semiconductor component by injection molding. This is likely to cause a defect of a product such as deformation or disconnection of a bonding wire.

A raw material used for the fused silica (B) according to the embodiment of the invention is obtained by separation of a quartz component from a mineral called pegmatite consisting of quartz, feldspar, and mica by floatation. The raw material may also be silica powder prepared by, for example, a direct method, a soot remelting method, a plasma method, a sol-gel method or an LPD method.

Production methods of the fused silica (B) are mainly classified into the electric melting method and the flame fusion method. Examples of the electric melting method include a method of melting silica in crucible in vacuo or in an inert gas atmosphere, a method of melting silica by arc plasma and a continuous tube blowing method of melting quartz powder and tube-blowing the melted quartz. The flame fusion method denotes a method of fusing quartz powder dropped from the center of a hydrogen-oxygen burner. Examples of the flame fusion method include a column method of producing fused silica without any contact and a slab method of producing large-size fused silica using a mold form.

Using crystalline silica or non-crystalline silica other than the fused silica (B) used in the invention significantly deteriorates the electric insulation that is essential for the sealing material of a semiconductor component, due to a large amount of ionic impurities such as $Na^+$, $Fe^{++}$, and $Cl^-$ other than silica.

According to the embodiment of the invention, the surface of the fused silica may be treated with a silane

coupling agent or the like to enhance the adhesion between the fused silica (B) and the PPS resin (A). The fused silica (B) may also be thermally treated fused silica for the purpose of removing the impurities and hardening the fused silica.

(C) Fibrous and/or Non-fibrous Filler

The PPS resin composition of the invention may include a fibrous and/or non-fibrous filler other than the fused silica (B).

Examples of the fibrous filler according to the embodiment of the invention include glass fibers, glass milled fibers, carbon fibers, ceramic fibers, and mineral fibers. Examples of the mineral fibers include potassium titanate whisker, zinc oxide whisker, calcium carbonate whisker, wollastonite whisker, asbestos fiber, and gypsum fiber. Examples of the ceramic fibers include alumina fiber and silicon carbide fiber. The preferable fibrous filler according to the embodiment of the invention is generally-called short fiber having a fiber length of 1 - 150 μm and a fiber diameter of 1 - 25 μm prior to mixing. Using such a short fiber filler is likely to provide a PPS resin composition for sealing a semiconductor component that minimizes deformation of a bonding wire and has the high strength and the high dimensional stability due to good dispersion of the filler.

Examples of the non-fibrous filler, on the other hand, include silicates such as wollastonite, zeolite, sericite, mica, talc, kaolin, clay, pyrophyllite, bentonite, asbestos, alumina silicate, and glass powder; metal compounds such as alumina, silicon oxide, magnesium oxide, zirconium oxide, titanium oxide, and iron oxide; carbonates such as calcium carbonate, magnesium carbonate, and dolomite; sulfates such as calcium sulfate and barium sulfate; hydroxides such as calcium hydroxide, magnesium hydroxide, and aluminum hydroxide; glass beads, ceramic beads, boron nitride, silicon carbide, graphite, carbon black and fullerene.

Among these fibrous and/or non-fibrous fillers (C), glass milled fiber, wollastonite, mica, talc and kaolin are preferable. Wollastonite and mica are especially preferable since these fillers achieve the low metal impurities, the high dimensional stability, and the high strength without significantly reducing the fluidity. The fibrous and/or non-fibrous filler (C) may be hollow and may be combined use of two or more of these fillers. Using these fillers after pretreatment with a coupling agent such as an isocyanate compound, an organosilane compound, an organotitanate compound, an organoborane compound, or an epoxy compound is preferable since this provides the better mechanical strength.

The mixing amount of the fibrous and/or non-fibrous filler (C) described above is 1 - 50 parts by weight relative to 100 parts by weight of the fused silica (B) described above. The upper limit is preferably 40 parts by weight and is more preferably 30 parts by weight, while the lower limit is preferably 5 parts by weight and is more preferably 10 parts by weight. It is desirable to mix not less than 1 part by weight of the component (C), since this further improves the dimensional stability and the mechanical strength by the synergistic effect of the component (B). The mixing amount of not greater than 50 parts by weight is also desirable since this maintains the good sealability as the PPS resin composition for sealing a semiconductor component without reducing the fluidity and the electric insulation of the PPS resin composition of the invention.

(D) PPS Resin Composition

The PPS resin composition according to the embodiment of the invention is unlikely to cause corrosion and ion migration of wiring, because of an extremely small amount of metal impurities included in the PPS resin (A) and the fused silica (B). Moreover, sealing of the PPS resin composition of the invention by injection molding provides a semiconductor package having excellent moisture proof reliability.

In order to achieve the excellent moisture proof reliability of the PPS resin composition of the invention, the ionic impurities by hot water extraction of a molded product of the PPS resin composition of the invention (20 g of sample / 100 ml of deionized water) at 160°C for 20 hours need to be lower than 50 ppm as the sodium content, lower than 50 ppm as the chlorine content and lower than 50 ppm as the iodine content. Preferably, the sodium content is lower than 20 ppm, the chlorine content is lower than 20 ppm, and the iodine content is lower than 20 ppm. More preferably, the sodium content is lower than 10 ppm, the chlorine content is lower than 10 ppm, and the iodine content is lower than 10 ppm.

When the PPS resin composition of the invention provides the sodium content of higher than 30 ppm, the chlorine content of higher than 20 ppm and the iodine content of 20 ppm as the ionic impurities included in the molded product described above, this undesirably causes significant reduction of the moisture proof reliability and is likely to induce malfunction of a semiconductor device.

Here the content of the ionic impurities (sodium content, chlorine content, and iodine content) in a molded product of the PPS resin composition of the invention may be measured by a method described below.

A molded product obtained by injection molding of the PPS resin composition of the invention is crushed and sieved through a sieve of 100 mesh, and 20 g of a sample is prepared. The sample is subsequently placed in 100 ml of deionized water and is heated at 160°C for 20 hours. The extract is sampled, and the sodium content, the chlorine

content and the iodine content thereof (measurement sensitivity: ppm order) are quantitatively determined by atomic absorption analysis using an atomic absorption spectrophotometer (AA-7000 manufactured by Shimadzu Corporation).

(D1) Other Additives

Additionally, a resin other than the PPS resin (A) may be added to the PPS resin composition according to the embodiment of the invention in such a range that does not damage the advantageous effects of the invention. Specific examples include polyamide resin, polybutylene terephthalate resin, polyethylene terephthalate resin, modified polyphenylene ether resin, polysulfone resin, polyarylsulfone resin, polyketone resin, polyarylate resin, liquid crystal polymer, polyether ketone resin, polythioether ketone resin, poly(ether ether ketone) resin, polyimide resin, polyamide imide resin, polytetrafluoroethylene resin and polyolefin polymers and copolymers without an epoxy group such as ethylene/ 1-butene copolymer.

The following compounds may further be added to the PPS resin composition for the purpose of modification: plasticizers such as polyalkylene oxide oligomer-based compounds, thioether-based compounds, ester-based compounds and organophosphorus-based compounds; crystal nucleating agents such as organophosphorus compounds and poly(ether ether ketone); metal soaps such as montanic acid waxes, lithium stearate and aluminum stearate; mold release agents such as ethylene diamine-stearic acid-sebacic acid polycondensates and silicone-based compounds; coloring inhibitors such as hypophosphites; phenolic antioxidants such as 3,9-bis[2-(3-(3-t-butyl-4-hydroxy-5-methylphenyl)propionyloxy)-1,1-dimetyle thyl]-2,4,8,10-tetraoxaspyro[5,5]undecane; phosphorus antioxidants such as bis(2,4-dicumylphenyl) pentaerythritol diphosphite; and other conventional additives including water, lubricants, ultraviolet ray inhibitors, coloring agents and foaming agents. When the mixing amount of the above compounds exceeds 20% by weight of the composition, this undesirably damages the inherent characteristic of the PPS resin (A). The mixing amount is thus preferably not higher than than 10% by weight and is more preferably not higher than 1% by weight.

(D2) Method of Producing PPS Resin Composition

The PPS resin composition according to the embodiment of the invention is generally obtained by melt kneading. A typical method employable for melt kneading feeds raw materials to a generally known melt kneader such as a single-screw extruder, a twin-screw extruder, a Banbury mixer, a kneader, or a mixing roll and kneads the raw materials at a processing temperature that is equal to the melt peak temperature of the PPS resin + 5 - 100°C. There is no specific limitation on the sequence of mixing the raw materials. Any of the following methods may be employed: a method of mixing all raw materials and subsequently melt kneading the mixture by the procedure described above, a method of mixing part of raw materials, melt kneading the mixture by the procedure described above, adding residual raw materials to the mixture and subsequently further melt kneading the resulting mixture, or a method of mixing part of raw materials and subsequently adding residual raw materials using a side feeder during melt kneading with a single-screw extruder or a twin-screw extruder. Minor additive components may be added prior to molding after melt kneading and pelletizing the other components by the above procedure or the like.

The composition according to the embodiment of the invention may be produced by a technique other than melt kneading. The mixture in the solid state may be compressed and pelletized and may subsequently be molded by injection molding or the like.

(D3) Molded Product

A molded product manufactured by molding the PPS resin composition according to the embodiment of the invention has the high fluidity, the high heat resistance, the low gas generation, the low ionic impurity, the high insulation, and the high dimensional stability. This allows for production of a semiconductor package that does not cause deformation of a bonding wire in the process of sealing a semiconductor component by injection molding and has excellent moisture proof reliability with no metal corrosion or ion migration. Furthermore, sealing a semiconductor component by injection molding of the PPS resin composition according to the embodiment of the invention remarkably improves the mass productivity compared with a conventional sealing process with a thermosetting resin and is also expected to provide the effects of low warpage and weight reduction by controlling the thickness of the sealed part.

The PPS resin composition according to the embodiment of the invention has the high fluidity, the high heat resistance, the low gas generation, the low ionic impurity, the high insulation, the high dimensional stability and the high mechanical strength and may be used to manufacture various molded products by injection molding, injection compression molding, blow molding or extrusion molding. The molded products formed from the PPS resin composition according to the embodiment of the invention may be applied to electric and electronic components, components of OA equipment for household use and business use; optical equipment and precision machine-related components, automobile and vehicle-related components, receiver components for underground electric power cables, and various other applications.

Among them, application to power semiconductor devices is especially preferable and is expected to be developed in a wide range of fields such as the field of household electric appliances (for example, rectifier circuits and regulators), the field of automobiles (for example, engine output and electronic control of electric components), the field of railway (for example, ultrahigh voltage power elements for motor control) and the field of solar and wind power generation (for example, inverter-related components).

2. Examples

The following more specifically describes the invention with reference to Examples. The invention is, however, not limited to Examples described below. In Examples described below, the material characteristics were measured by methods described below.

2-1. Measuring Methods

<Measurement of Molecular Weight>

The molecular weights of the polyphenylene sulfide and the polyphenylene sulfide prepolymer were measured by gel permeation chromatography (GPC), a kind of size exclusion chromatography (SEC), and were calculated in polystyrene conversion. The following provides measurement conditions of GPC:

Apparatus: SSC-7110 manufactured by Senshu Scientific Co., Ltd.
Column: GPC3506 manufactured by Senshu Scientific Co., Ltd.
Eluent: 1-chloronaphthalene
Detector: differential refractive index detector
Column temperature: 210°C
Pre-thermostatic bath temperature: 250°C
Pump thermostatic bath temperature: 50°C
Detector temperature: 210°C
Flow rate: 1.0 mL/min
Sample injection volume: 300 μL (sample concentration: about 0.2% by weight)

<Measurement of Weight Reduction Ratio of PPS Resin on Heating>

The weight reduction ratio of polyphenylene sulfide on heating was measured under the following conditions using a thermogravimetric analyzer. The sample used was fine particles of not larger than 2 mm:

Apparatus: TGA7 manufactured by PerkinElmer Co., Ltd.
Atmosphere for measurement: under nitrogen stream
Weight of fed sample: about 10 mg
Measurement conditions:

(a) keeping at a programmed temperature of 50°C for 1 minute; and
(b) raising the temperature from the programmed temperature of 50°C to 400°C with a temperature rise rate of 20°C/ minute.

The weight reduction ratio ΔWr was calculated according to Equation (3) given below from a sample weight (W2) at temperature reaching 330°C relative to a sample weight (W1) at temperature reaching 100°C in the temperature raising (b):

$$\Delta Wr = (W1 - W2) / W1 \times 100(\%) \qquad (3)$$

In examples described below, the weight reduction ratio obtained from the sample weight at 300°C relative to the sample weight at 100°C and expressed as ΔWr300, the weight reduction ratio obtained from the sample weight at 320°C relative to the sample weight at 100°C and expressed as ΔWr320, and the weight reduction ratio obtained from the sample weight at 340°C relative to the sample weight at 100°C and expressed as ΔWr340 are shown for reference.

<Measurement of Alkali Metal Content in PPS Resin>

The alkali metal content contained in the polyphenylene sulfide resin was quantitatively determined by the following method:

(a) A sample was weighed in a quartz crucible and was incinerated using an electric oven;
(b) The ash was dissolved in concentrated nitric acid and was subsequently diluted to a predetermined volume with dilute nitric acid; and
(c) The alkali metal content in the resulting solution was measured by ICP mass spectrometry (apparatus: 4500 manufactured by Agilent Technologies) and ICP atomic emission spectrometry (Optima 4300DV manufactured by PerkinElmer Co., Ltd.)

<Analysis of Gas Component Generated from PPS Resin on Heating>

The components generated from the polyphenylene sulfide resin on heating were quantitatively determined by the following method. The sample used was fine particles of not larger than 2 mm:

(a) Trapping of gas generated on heating

About 10 mg of the polyphenylene sulfide resin was heated at 320°C for 60 minutes under nitrogen stream (50 ml / minute), and the generated gas component was trapped by a gas-trapping thermal desorption tube carbotrap 400.

(b) Analysis of gas component

The gas component trapped by the above tube was thermally desorbed by increasing the temperature from room temperature to 280°C in 5 minutes using a thermal desorption apparatus TDU (manufactured by Sigma-Aldrich Corporation). After separation of the thermally desorbed component by gas chromatography, the amount of γ-butyrolactone in the gas was measured as the amount of lactone-type compound and the amount of 4-chloro-N-methylanilime was measured as the amount of aniline-type compound.

<Bar Flow Length>

Ten molded pieces of 150 mm (in length) × 12.6 mm (in width) × 0.5 mm (in thickness) were successively formed by injection molding (gate position: width side of each molded piece, gate form: film gate) under the conditions of the resin temperature of 320°C, the mold temperature of 130°C, the injection speed set to 99 %, and the injection pressure set to 45 % (actual injection pressure of 98 MPa) using an injection molding apparatus PROMAT 40/20 manufactured by Sumitomo Heavy Industries, Ltd. The filling terminal length in the longitudinal direction of each molded piece was measured from the gate position, and its average value was defined as the bar flow length. The larger bar flow length indicates the better thin-wall fluidity.

<Injection Molding of Tensile Test Piece>

An ASTM No. 1 dumbbell test piece was molded under the conditions of the resin temperature of 320°C and the mold temperature of 130°C using an injection molding apparatus SE 75-DUZ manufactured by Sumitomo Heavy Industries, Ltd.

<Tensile Test>

The tensile strength and the tensile elongation of the above injection-molded ASTM No. 1 dumbbell test piece were measured under the conditions of the span of 114 mm and the tension rate of 10 mm/ min using a tension tester Tensilon UTA2.5T in conformity with ASTM D638. The larger values indicate the better tensile characteristics.

<Injection Molding of Bending Test Piece>

A bending test piece of 12.5 mm (in width) × 130 mm (in length) × 3.2 mm (in thickness) was molded under the conditions of the resin temperature of 320°C and the mold temperature of 130°C using an injection molding apparatus SE 75-DUZ manufactured by Sumitomo Heavy Industries, Ltd.

<Bending Test>

The bending strength and the bending elastic modulus of the above injection-molded bending test piece were measured under the conditions of the span of 100 mm and the crosshead speed of 1.0 mm/ min using a bending tester Tensilon RTM1T in conformity with ASTM D790. The larger values indicate the better bending characteristics.

<Measurement of Deflection Temperature under Load>

The deflection temperature under load of the above injection-molded bending test piece was measured under the load of 0.45 MPa in conformity with ASTM D648. The higher value indicates the better heat resistance.

<Injection Molding of Impact Test Piece>

An Izod impact test piece with mold notch of 12.7 mm (in width) × 60 mm (in length) × 3.2 mm (in thickness) was molded under the conditions of the resin temperature of 320°C and the mold temperature of 130°C using an injection molding apparatus SE 75-DUZ manufactured by Sumitomo Heavy Industries, Ltd.

<Izod Impact Test>

The notched Izod impact strength of the above injection-molded Izod impact test piece with mold notch was measured in conformity with ASTM D256. The higher value indicates the better impact characteristic.

<Material Specific Gravity>

The specific gravity of the above injection-molded Izod impact test piece with mold notch was measured by downward displacement of water using an electronic densitometer ED-120T manufactured by Alfa Mirage Co., Ltd.

<Measurement of Weight Loss by Heating of PPS Resin Composition>

Pellets of the PPS resin composition obtained by melt kneading the mixture and drying the melt-kneaded mixture at 120°C for 8 hours in the atmosphere were preliminarily dried at 130°C for 3 hours, and about 10 g of the pellets was precisely weighed in an aluminum cup. The weight loss by heating ΔWh was measured after heat treatment at 320°C for 2 hours in the atmosphere. The weight loss by heating ΔWh was calculated from the sample weight after heating (W4) relative to the sample weight before heating (W3) according to Equation (4) given below:

$$\Delta Wh = (W3\text{-}W4)/W3 \times 100 \qquad (4)$$

The lower weight loss by heating indicates the lower gas generation amount.

<Linear Expansion Coefficient

A plate of 70 mm (in length) × 70 mm (in width) × 1.0 mm (in thickness) (gate form: film gate, mold mirror surface roughness: 0.03 s) was molded under the conditions of the resin temperature of 320°C and the mold temperature of 150°C using an injection molding apparatus SE 75-DUZ manufactured by Sumitomo Heavy Industries, Ltd. Measurement test pieces in a rectangular columnar shape of 3 mm in width × 15 mm in length × 1 mm in thickness were cut from a middle portion of this plate in a resin flow direction (MD direction) and in a direction orthogonal to the flow direction (TD direction). The linear expansion coefficient at 30 - 50°C was measured using these measurement test pieces by an apparatus TMA manufactured by Seiko Instruments, Inc. The smaller value indicates the better dimensional stability.

<Rockwell Hardness>

A plate of 80 mm (in length) × 80 mm (in width) × 3.0 mm (in thickness) (gate form: film gate, mold mirror surface roughness: 0.03 s) was molded under the conditions of the resin temperature of 320°C and the mold temperature of 150°C using an injection molding apparatus SE 75-DUZ manufactured by Sumitomo Heavy Industries, Ltd. The Rockwell hardness of this plate in R scale (measuring terminal: 1/2 inch steel ball of 12.7 mm in diameter) was measured in conformity with ISO 2039-2 standard using a Rockwell hardness tester manufactured by Toyo Seiki Seisaku-sho, Ltd.

The smaller value indicates the lower surface hardness of the material. This reduces the mold abrasion during injection molding and damage on the bonding wire and accordingly provides the better molding processability.

<Arc Resistance (Insulation Property)>

The arc resistance of the above injection-molded Rockwell hardness test piece was measured in conformity with JIS K6911 as a time duration (seconds) until electrical continuity and ignition by arc discharge on the surface of a molded product using an arc resistance tester manufactured by Tokyo Seiden Co., Ltd. (temperature of 23°C, humidity of 50 %, n = 4). The longer time duration indicates the better arc resistance and is more suitable for producing a semiconductor component of excellent insulation property.

<Metal Corrosion>

Pellets of the PPS resin composition obtained by melt kneading the mixture and drying the melt-kneaded mixture at 120°C for 8 hours in the atmosphere were preliminarily dried at 130°C for 3 hours, and about 20 g of the pellets was precisely weighed in an aluminum cup. A copper plate (10 mm in width × 20 mm in length × 1.0 mm in thickness) was placed on the pellets spread in the aluminum cup. After the top of the aluminum cup was covered by a glass Petri dish, the aluminum cup was heated in a hot air oven at 300°C for 30 minutes. The centerline average roughness Ra of the copper plate surface before and after the heating treatment was measured (in conformity with JIS B0601), and a change rate in Ra of the copper plate surface was calculated by an equation given below. The metal corrosion by a volatile component was simply evaluated based on the calculated change rate in Ra of the copper plate surface. The smaller value indicates the lower possibility of metal corrosion.

<Evaluation of Mold Deposit>

Evaluation was performed using an injection molding apparatus SE 75-DUZ manufactured by Sumitomo Heavy Industries, Ltd. with respect to a mold for gas evaluation that provides the maximum length of 55 mm, the width of 20 mm, and the thickness of 2 mm as the size of a molded production 10 shown in Fig. 1, the width of 2 mm and the thickness of 1 mm (side gate) as the gate size (G in Figure 1 denotes gates), and the maximum length of 20 mm, the width of 10 mm, and the depth of 5 μm as the size of a gas vent. Continuous molding was performed under the conditions of the cylinder temperature of 330°C, the mold temperature of 150°C, the injection speed of 100 mm/s, the injection pressure set to 50 - 80 MPa such as to provide the filling time of 0.4 seconds per resin composition, the keeping pressure of 25 MPa, the pressure keeping rate of 30 mm/ s, and the pressure keeping time of 3 seconds. Continuous molding was performed until some mold deposit was visually recognized on the gas vent and the cavity. The larger number of shots in continuous molding until visual recognition of the mold deposit indicates the better mold deposit property.

<Sodium Content, Chlorine Content and Iodine Content in Extracting Solution>

The above injection-molded ASTM No. 1 dumbbell test piece was crushed and was sieved through a sieve of 100 mesh, so that 20 g of a measurement sample was prepared. The measurement sample was added to 100 ml of deionized water (in a glass beaker) and extraction into water was performed by heating at 160°C for 20 hours. The sodium content, the chlorine content, and the iodine content in the extracting solution were measured by atomic absorption spectrophotometry (AA-7000 manufactured by Shimadzu Corporation). The lower values indicate the better moist proof reliability of a semiconductor package.

<Wire Deformation Rate>

Sixty packages were molded with a mold for 208 pin LQFP (outer dimension: 28 mm × 28 mm × 1.4 mm in thickness, frame material: 42 alloy) under the conditions of the resin temperature of 320°C and the mold temperature of 130°C using an injection molding apparatus PROMAT 40/20 manufactured by Sumitomo Heavy Industries, Ltd. A simulation element (chip size: 12.7 mm × 12.7 mm × 0.3 mm in thickness) coated with a silicon nitride film was mounted as a silicon chip for evaluation. Bonding wires were 120 (30 each side) Al wires (wire diameter of 100 μm) bonded to the inner lead terminal and the silicon chip. The wire deformation rate was calculated from the number of deformed Al wires among the 60 packages of 208 pin LQFP obtained by the above molding, based on comparison with an image prior to the molding using an X-ray inspection apparatus (manufactured by Hitachi Construction Machinery Co., Ltd.) The lower wire deformation rate indicates the better semiconductor sealing property.

2-2. Reference Examples

The following describes reference examples 1 to 7 used for the compositions of Examples 1 to 8 and Comparative Examples 1 to 9.

[Reference Example 1] Polymerization of (A-1) polyphenylene sulfide resin having the weight-average molecular weight of not less than 10000 and the polydispersity calculated by dividing the weight-average molecular weight by the number-average molecular weight, of not higher than 2.5:

A mixture of 1.648 kg of a 48% by weight sodium hydrosulfide aqueous solution (0.791 kg (14.1 mol) of sodium hydrosulfide), 1.225 kg of a 48% by weight sodium hydroxide aqueous solution (0.588 kg (14.7 mol) of sodium hydroxide), 35 L of N-methyl-2-pyrolidone (NMP), and 2.120 kg (14.4 mol) of p-dichlorobenzene (p-DCB) was prepared in an autoclave equipped with an agitator and a top leak valve.

After the reaction vessel was sealed in a nitrogen atmosphere at room temperature and ordinary pressure, the mixture was heated from room temperature to 200°C in 25 minutes with stirring at 400 rpm. The mixture was further heated to 250°C in 35 minutes and was kept at 250°C for 2 hours for the reaction. While the internal temperature was kept at 250 °C, the leak valve was gradually opened and 26.6 kg of the solvent was distilled out in 40 minutes. After completion of distillation-out of the solvent, the autoclave was cooled down to approximately room temperature, and the content of the autoclave was recovered.

The recovered content was heated with stirring in a nitrogen atmosphere such that the temperature of the reaction solution reached 100°C. After the reaction solution was kept at 100°C for 20 minutes, solid-liquid separation was performed using a stainless steel wire gauze having the mean aperture of 10 μm. The filtrate obtained was dropped into an about 3-fold volume of methanol, and the precipitation component was recovered. The solid component recovered after precipitation was dispersed to slurry in about 2.5 L of hot water at 80 °C, and was stirred at 80°C for 30 minutes and was then filtrated. This series of operations was repeated three times. The solid component obtained by filtration was dried at 80°C under reduced pressure for 8 hours, so that a dried solid was obtained. Infrared spectroscopy and high performance liquid chromatography showed that the dried solid obtained contained 85% by weight of cyclic polyphenylene sulfide.

After the obtained dried solid was placed in a glass test tube equipped with a distillation pipe and an agitation blade, pressure reduction and replacement with nitrogen in the test tube were repeated three times. The test tube was heated at temperature controlled to 340°C for 120 minutes, while the internal pressure of the test tube was kept at about 0.1 kPa. The test tube was then cooled down to room temperature, so that a polymer was obtained. The obtained product was identified as polyphenylene sulfide based on an infrared spectroscopy. GPC measurement showed that the obtained product had the weight-average molecular weight of about 50000 and the polydispersity of 2.35. Measurement of the weight reduction rate on heating of the obtained product showed that ΔWr was 0.055%; ΔWr300(%) = 0.035, ΔWr320(%) = 0.044 and ΔWr340(%) = 0.060. Quantitative determination of the alkali metal contents of the obtained product showed that the Na content was 70 ppm as the weight ratio and that other alkali metals were not detected. Analysis of the gas component generated on heating of the obtained product showed that the amounts of both the lactone-type compound and the aniline-type compound were lower than their detection limits. The product obtained as described above is called PPS resin (A-1).

[Reference Example 2] Polymerization of (A-2) polyphenylene sulfide resin having the weight-average molecular weight of not less than 10000 and the polydispersity calculated by dividing the weight-average molecular weight by the number-average molecular weight, of not higher than 2.5:

Reference Example 2 was prepared by the same procedure as that of Reference Example 1, except that the mixing amount of p-dichlorobenzene was changed to 2.278 kg (15.5 mol). Analyses showed that a dried solid obtained contained 72% by weight of cyclic polyphenylene sulfide. The obtained polymer had the weight-average molecular weight of about 20000 and the polydispersity of 1.90. Measurement of the weight reduction rate on heating of the obtained product showed that ΔWr was 0.065%; ΔWr300(%) = 0.045, ΔWr320(%) = 0.055 and ΔWr340(%) = 0.070. Quantitative determination of the alkali metal contents of the obtained product showed that the Na content was 280 ppm as the weight ratio and that other alkali metals were not detected. Analysis of the gas component generated on heating of the obtained product detected 24 ppm of γ-butyrolactone and 19 ppm of 4-chloro-N-methylaniline relative to the weight of the product prior to heating. The product obtained as described above is called PPS resin (A-2).

[Reference Example 3] Polymerization of (A'-1) polyphenylene sulfide resin having the weight-average molecular weight of not less than 10000 and the polydispersity calculated by dividing the weight-average molecular weight by the number-average molecular weight, of not lower than 2.5:

A mixture of 8.27 kg (70.00 mol) of 47.5% sodium hydrosulfide, 2.94 kg (70.63 mol) of 96% sodium hydroxide, 11.45 kg (115.50 mol) of N-methyl-2-pyrolidone (NMP), 1.89 kg (23.1 mol) of sodium acetate and 5.50 kg of deionized water was prepared in a 70 liter autoclave equipped with an agitator and a bottom valve and was gradually heated to 245°C in about 3 hours at ordinary pressure with a nitrogen stream. After distillation of 9.77 kg of water and 0.28 kg of NMP by heating, the reaction vessel was cooled down to 200°C. The residual water content in the system per 1 mol of the alkali metal sulfide added was 1.06 mol including the water content consumed by hydrolysis of NMP. The release amount of hydrogen sulfide per 1 mol of the alkali metal sulfide added was 0.02 mol.

After the reaction vessel was cooled down to 200°C, 10.42 kg (70.86 mol) of p-dichlorobenzene and 9.37 kg (94.50 mol) of NMP were added to the reaction vessel. The reaction vessel was then sealed in a nitrogen atmosphere and was heated from 200°C to 270°C at a temperature rise rate of 0.6°C/ min with stirring at 240 rpm. After the temperature rise, the reaction was performed at 270°C for 140 minutes. After that, 2.40 kg (133 mol) of water was pressed into the reaction vessel, while the reaction vessel was cooled down from 270°C to 250°C in 15 minutes. The reaction vessel was further cooled down gradually from 250°C to 220°C in 75 minutes and was quenched to about room temperature, and the content of the reaction vessel was then taken out.

The content was diluted to slurry with about 35 liters of NMP, was stirred at 85°C for 30 minutes, and was filtrated through an 80-mesh wire gauge (aperture of 0.175 mm), so that a solid was obtained. The solid obtained was similarly washed with about 35 liters of NMP and was filtrated. The solid obtained was added to 70 liters of deionized water, was stirred at 70°C for 30 minutes, and was filtrated through the 80-mesh wire gauge, so that a solid was recovered. This series of operations was repeated a total of three times. The obtained solid was added together with 32 g of acetic acid to 70 liters of deionized water, was stirred at 70°C for 30 minutes, and was filtrated through the 80-mesh wire gauge. The obtained solid was further added to 70 liters of deionized water, was stirred at 70°C for 30 minutes, and was filtrated through the 80-mesh wire gauge, so that a solid was recovered. The solid obtained as described above was dried at 120°C in a nitrogen stream, so that a dried PPS resin (PPS resin (A'-1)) was obtained.

The obtained dried PPS resin was fully soluble in 1-chloronaphthalene at 210°C. GPC measurement showed that the obtained dried PPS resin had the weight-average molecular weight of 48600 and the polydispersity of 2.66. Measurement of the weight reduction rate on heating of the obtained dried PPS resin showed that $\Delta$Wr was 0.23%; $\Delta$Wr300(%) = 0.18, $\Delta$Wr320(%) = 0.21 and $\Delta$Wr340(%) = 0.25. Quantitative determination of the alkali metal contents of the obtained dried PPS resin showed that the Na content was 120 ppm as the weight ratio and that other alkali metals were not detected. Analysis of the gas component generated on heating of the obtained dried PPS resin detected 1190 ppm of $\gamma$-butyrolactone and 240 ppm of 4-chloro-N-methylaniline relative to the weight of the product prior to heating.

[Reference Example 4] Polymerization of (A'-2) polyphenylene sulfide resin having the weight-average molecular weight of not less than 10000 and the polydispersity calculated by dividing the weight-average molecular weight by the number-average molecular weight, of not lower than 2.5:

A mixture of 8.27 kg (70.00 mol) of 47.5% sodium hydrosulfide, 2.91 kg (69.80 mol) of 96% sodium hydroxide, 11.45 kg (115.50 mol) of N-methyl-2-pyrolidone (NMP) and 10.5 kg of deionized water was prepared in a 70 liter autoclave equipped with an agitator and a bottom valve and was gradually heated to 245°C in about 3 hours at ordinary pressure with a nitrogen stream. After distillation of 14.78 kg of water and 0.28 kg of NMP by heating, the reaction vessel was cooled down to 200°C. The residual water content in the system per 1 mol of the alkali metal sulfide added was 1.06 mol including the water content consumed by hydrolysis of NMP. The release amount of hydrogen sulfide per 1 mol of the alkali metal sulfide added was 0.02 mol.

After the reaction vessel was cooled down to 200°C, 10.48 kg (71.27 mol) of p-dichlorobenzene and 9.37 kg (94.50 mol) of NMP were added to the reaction vessel. The reaction vessel was then sealed in a nitrogen atmosphere and was heated from 200°C to 270°C at a temperature rise rate of 0.6°C/ min with stirring at 240 rpm. After the reaction was performed at 270°C for 100 minutes, the bottom valve of the autoclave was opened, and the content was flushed out into a vessel equipped with an agitator under pressurization with nitrogen in 15 minutes. The content was stirred at 250°C for some time, so that most of NMP was removed.

The obtained solid was placed along with 76 liters of deionized water in an autoclave equipped with an agitator, was washed at 70°C for 30 minutes, and was filtrated through a glass filter under reduced pressure. A cake was obtained by pouring 76 liters of deionized water heated to 70°C into the glass filter and subsequently performing suction filtration. The obtained cake was placed together with 90 liters of deionized water into an autoclave equipped with an agitator, and acetic acid was added to adjust pH to 7. After the inner space of the autoclave was replaced with nitrogen, the autoclave was heated to 192°C and was kept at 192°C for 30 minutes. The autoclave was then cooled down, and the

content was taken out. The content was filtrated through a glass filter under reduced pressure. A cake was obtained by pouring 76 liters of deionized water heated to 70°C into the glass filter and subsequently performing suction filtration. The obtained cake was dried at 120°C with a nitrogen stream, so that a dried PPS resin (PPS resin (A'-2)) was obtained.

The obtained dried PPS resin was fully soluble in 1-chloronaphthalene at 210°C. GPC measurement showed that the obtained dried PPS resin had the weight-average molecular weight of 20000 and the polydispersity of 3.10. Measurement of the weight reduction rate on heating of the obtained product showed that ΔWr was 0.53%. Quantitative determination of the alkali metal contents of the obtained product showed that the Na content was 980 ppm as the weight ratio and that other alkali metals were not detected. ΔWr300(%) = 0.48, ΔWr320(%) = 0.50 and ΔWr340(%) = 0.55.

[Reference Example 5] (B) Fused Silica in spherical shape having volume-average particle diameter of 0.1 μm - 1.0 μm

(B-1) Fused silica (SFP-30M manufactured by Denka Company Limited, volume-average particle diameter of 0.7 μm, spherical)
(B-2) Fused silica (SFP-20M manufactured by Denka Company Limited, volume-average particle diameter of 0.3 μm, spherical)

[Reference Example 6] (B') Fused Silica in spherical shape having volume-average particle diameter of greater than 1.0 μm

(B'-1) Fused silica (FB-20D manufactured by Denka Company Limited, volume-average particle diameter of 23 μm, spherical)

The volume-average particle diameter in (B'-1) was determined by a laser diffraction and diffusion particle size distribution measuring apparatus LA-300 manufactured by HORIBA, Ltd.

[Reference Example 7] (C) Fibrous and/or Non-fibrous Filler other than (B) Fused Silica

(C-1) Wollastonite (NYAD1250 manufactured by TOMOE Engineering Co., Ltd., mean fiber diameter of 3 μm, mean fiber length of 9 μm, aspect ratio of 3, fibrous)
The mean fiber diameter and mean fiber length in (C-1) were calculated as number average values by observing an image at 2000-fold magnification using a scanning electron microscope (SEM) (JSM-6360LV manufactured by JEOL Ltd.), selecting 10 pieces of the fibrous filler at random from the image and measuring their fiber lengths and fiber diameters. The aspect ratio was calculated as the mean fiber length (μm)/ the mean fiber diameter (μm).
(C-2) Mica (SJ005 manufactured by YAMAGUCHI MICA CO., LTD., volume-average particle diameter of 5 μm, aspect ratio of 100, plate-like)
(C-3) Heavy calcium carbonate (KSS1000 manufactured by CALFINE Co., Ltd., volume-average particle diameter of 4.2 μm, granular)
(C-4) Low-sodium fine particle alumina (LS-200 manufactured by Nippon Light Metal Company, Ltd., volume-average particle diameter of 2.7 μm, granular)
(C-5) Glass bead (EGB731 manufactured by Potters-Ballotini Co., Ltd., volume-average particle diameter of 20 μm, spherical)

The volume-average particle diameter in (C-2) to (C-5) was determined by a laser diffraction and diffusion particle size distribution measuring apparatus LA-300 manufactured by HORIBA, Ltd. The thickness was determined by observing an image at 2000-fold magnification using a scanning electron microscope (SEM) (JSM-6360LV manufactured by JEOL Ltd.). The thickness was calculated as a number average value by selecting 10 filler particles at random from the image and measuring their thicknesses. The aspect ratio was then calculated as the volume-average particle diameter (μm)/ the number average thickness (μm).

2-3. Methods of Producing Examples 1 to 8 and Comparative Examples 1 to 9 and their Evaluations

The component (A) and the component (B) shown in Table 1 and Table 2 were dry-blended at the ratios shown

in Table 1 and Table 2. The dry-blended components (A) and (B) were fed from a base (position of L/D= 45.5 from a die head) of a twin-screw extruder equipped with a vacuum vent (L/D= 45.5, five kneading sections) TEX30$\alpha$ manufactured by the Japan Steel Works, LTD., were melt-kneaded under extrusion conditions of the screw rotation speed of 300 rpm and the cylinder temperature set to provide the resin temperature of the die ejection portion of not higher than 330°C, and were pelletized. The component (C) was fed in the middle using a side feeder from a position of L/D= 15 from the die head, such as to achieve the ratios shown in Table 1 and Table 2. The obtained pellets were dried at 130°C overnight, were injection molded and were evaluated for the material specific gravity, the weight loss by heating, the Rockwell hardness, the bar flow length, the tensile characteristics, the bending characteristics, the impact characteristic, the deflection temperature under load, the linear expansion coefficient, the metal corrosion, the arc resistance, the contents of ionic impurities, the mold deposit and the wire deformation rate. The results of evaluation are shown in Table 1 and Table 2.

[Table 1]

[Table 2]

The results of Examples 1 to 8 and Comparative Examples 1 to 9 are described in comparison.

Example 1 obtained by mixing the PPS resin (A-2) with the fused silica (B-1) has the improved arc resistance and the significantly reduced wire deformation rate and accordingly has the better semiconductor sealing property, compared with Comparative Example 1 similar to Example 1 except replacement of the fused silica (B-1) with the fused silica (B'-1). Example 8 similar to Example 1 except replacement of the fused silica (B-1) with the fused silica (B-2) has the smaller volume-average particle diameter of the fused silica (B) such as to further improve the dimensional stability and reduces the wire deformation rate. Additionally, in Example 2 using the PPS resin (A-1) in addition to the PPS resin (A-2) used in Example 1, combining two different types of PPS resins further improves the tensile characteristics, the bending characteristics and the impact characteristic.

As shown in Examples 3 to 7, mixing the fibrous filler or the non-fibrous filler (C) other than the component (B) with the PPS resin (A-2) and the fused silica (B-1) of Example 1 provides the high strength and the high dimensional stability, in addition to the excellent arc resistance and the excellent semiconductor sealing property of Example 1, and accordingly provides the higher practical performance.

Comparative Example 1 similar to Example 1 except replacement of the PPS resin (A-2) with the PPS resin (A'-2), on the other hand, has the high contents of ionic impurities and the high gas generation amount. This provides the increased metal corrosion and the increased mold deposit and significantly reduces the moist proof reliability. Additionally, Comparative Examples 3 and 4 produced by replacing the PPS resin (A-2), the PPS resin (A-1) and the fused silica (B-1) used in Examples 1 and 2 with the PPS resin (A'-2), the PPS resin (A'-1) and the fused silica (B'-1) provides the low arc resistance and the poor semiconductor sealing property, significantly increases the mold deposit, and significantly reduces the moist proof reliability. This provides the poor practical performance. Comparative Examples 5 to 7 produced by adding the components (C-3), (C-4) and (C-5) in place of the fused silica (B-1) used in Example 1 fail to significantly both the arc resistance and the semiconductor sealing property. This does not achieve the practically satisfactory level.

Reference Signs List

G Gate
10 Molded product

## Claims

**1.** A polyphenylene sulfide resin composition, comprising:

5 - 50% by weight of a component (A) that is a polyphenylene sulfide resin having a weight-average molecular weight of not less than 10000 and a polydispersity, which is expressed by dividing the weight-average molecular weight by a number-average molecular weight, of not higher than 2.5; and
95 - 50% by weight of a component (B) that is fused silica in a spherical form having a volume-average particle diameter of not less than 0.1 $\mu$m and less than 1.0 $\mu$m, wherein a total of the components (A) and (B) is kept

at 100% by weight.

2. The polyphenylene sulfide resin composition according to claim 1,
wherein an extracting solution obtained by hot water extraction (20 g of a sample / 100 ml of deionized water) at 160°C for 20 hours of a molded product formed from the polyphenylene sulfide resin composition has a sodium content of lower than 50 ppm, a chlorine content of lower than 50 ppm and an iodine content of lower than 50 ppm.

3. The polyphenylene sulfide resin composition according to either claim 1 or claim 2, further comprising:

   1 - 50 parts by weight of (C) a fibrous and/or non-fibrous filler other than (B) the fused silica, relative to 100 parts by weight of the component (B).

4. The polyphenylene sulfide resin composition according to any one of claims 1 to 3,
wherein the component (A) is a polyphenylene sulfide resin that includes at least 50% by weight or more of a cyclic polyphenylene sulfide expressed by General Formula (I) given below:

[Chem. 1]

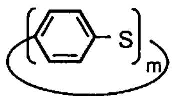

••• (I)

(wherein m is an integral number of 4 - 20, and the component (A) is allowed to be configured as a mixture of multiple different types of cyclic polyphenylene sulfides having different numbers m) and that is obtained by heating a polyphenylene sulfide prepolymer having a weight-average molecular weight of less than 10000 such as to be converted to a high molecular-weight polymer having a weight-average molecular weight of not less than 10000.

5. A molded product formed from the polyphenylene sulfide resin composition according to any one of claims 1 to 4.

6. The molded product according to claim 5,
the molded product being configured as a semiconductor package.

7. A method of producing a semiconductor package, comprising
sealing a semiconductor component by injection molding the polyphenylene sulfide resin composition according to any one of claims 1 to 4.

Fig. 1

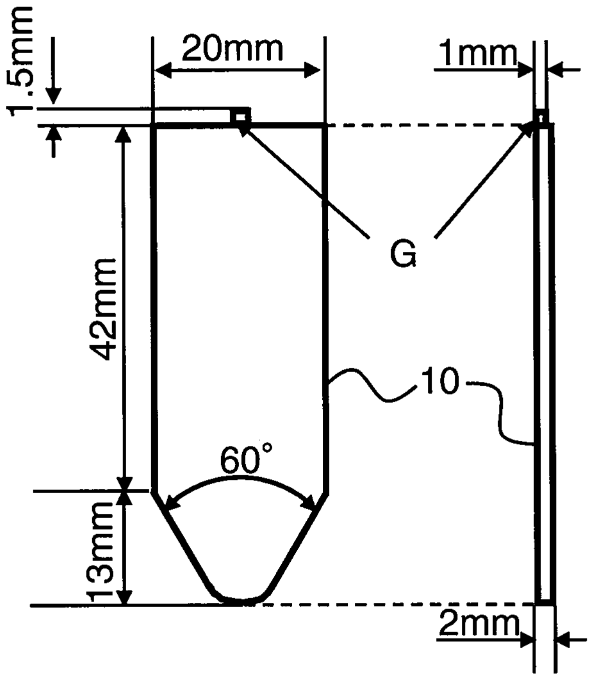

**INTERNATIONAL SEARCH REPORT**

International application No.
PCT/JP2016/000985

A. CLASSIFICATION OF SUBJECT MATTER
*C08L81/02*(2006.01)i, *B29C45/00*(2006.01)i, *C08K3/36*(2006.01)i, *C08K7/02*(2006.01)i, *H01L23/29*(2006.01)i, *H01L23/31*(2006.01)i

According to International Patent Classification (IPC) or to both national classification and IPC

B. FIELDS SEARCHED

Minimum documentation searched (classification system followed by classification symbols)
C08L81/02, B29C45/00, C08K3/36, C08K7/02, H01L23/29, H01L23/31

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2016 |
| Kokai Jitsuyo Shinan Koho | 1971-2016 | Toroku Jitsuyo Shinan Koho | 1994-2016 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2007-154071 A (Sumitomo Electric Industries, Ltd.), 21 June 2007 (21.06.2007), claims; paragraphs [0026] to [0033], [0057]; examples (Family: none) | 1-7<br>1-7 |
| Y | JP 2008-231140 A (Toray Industries, Inc.), 02 October 2008 (02.10.2008), claims; paragraphs [0022] to [0079], [0160]; examples (Family: none) | 1-7 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 01 April 2016 (01.04.16) | 12 April 2016 (12.04.16) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

**INTERNATIONAL SEARCH REPORT**

International application No.
PCT/JP2016/000985

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2008-231138 A (Toray Industries, Inc.), 02 October 2008 (02.10.2008), claims; paragraphs [0024] to [0080], [0161]; examples (Family: none) | 1-7 |
| A | JP 2000-204252 A (Idemitsu Petrochemical Co., Ltd.), 25 July 2000 (25.07.2000), claims; examples & US 2002/0055582 A1 & WO 2000/042108 A1 & EP 1065246 A1 & DE 60012633 D & DE 60012633 T | 1-7 |
| A | WO 2002/083792 A1 (Idemitsu Petrochemical Co., Ltd.), 24 October 2002 (24.10.2002), claims; examples & JP 4796268 B & US 2004/0116586 A1 & EP 1384756 A1 & KR 10-2003-0096309 A | 1-7 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2008231138 A
- JP 2000034407 A
- JP 2000186209 A